# EUROPÄISCHE PATENTSCHRIFT

(11) **EP 1 138 114 B1**
(45) Veröffentlichungstag und Bekanntmachung des Hinweises auf die Patenterteilung: **14.08.2002**
(21) Anmeldenummer: 98955300.3
(22) Anmeldetag: 01.12.1998
(51) Int. Cl.: H03B 28/00, H04Q 7/32

(54) **OSZILLATOR UND TELEKOMMUNIKATIONSSYSTEM MIT EINEM SOLCHEN OSZILLATOR**
OSCILLATOR AND TELECOMMUNICATIONS SYSTEM WITH SUCH AN OSCILLATOR
OSCILLATEUR ET SYSTEME DE TELECOMMUNICATION POURVU D'UN TEL OSCILLATEUR

(43) Veröffentlichungstag der Anmeldung: 04.10.2001
(73) Patentinhaber: Swisscom Mobile AG, 3050 Bern (CH)
(72) Erfinder: RITTER, Rudolf, CH-3052 Zollikofen (CH)
(74) Vertreter: Scheuzger, Beat Otto
(86) Internationale Anmeldenummer: CH9800506
(87) Internationale Veröffentlichungsnummer: WO0033456

(56) Entgegenhaltungen:
- FR-A- 2 642 533
- GB-A- 2 308 528
- US-A- 5 497 385
- BRAUN R -P ET AL: "LOW-PHASE-NOISE MILLIMETER-WAVE GENERATION AT 64 GHZ AND DATA TRANSMISSION USING OPTICAL SIDEBAND INJECTION LOCKING" IEEE PHOTONICS TECHNOLOGY LETTERS, Bd. 10, Nr. 5, 1. Mai 1998 (1998-05-01), Seiten 728-730, XP000754669 ISSN: 1041-1135 in der Anmeldung erwähnt

## Beschreibung

Die vorliegende Erfindung betrifft eine Chipkarte mit einem auf ihr integrierten Oszillator. Insbesondere betrifft die Erfindung auch Telekommunikationssysteme und -Verfahren, die eine solche Chipkarte verwenden.

Viele tragbare elektronische Systeme erfordern einen miniaturisierten Oszillator, der ein Signal mit einer stabilen Frequenz erzeugen kann. Quarzoszillatoren werden häufig zu diesem Zweck verwendet, da sie wenig Strom verbrauchen und leicht in kleinen Geräten, zum Beispiel in Armbanduhren, integriert werden können.

Eine Vielzahl von Versuchen wurde schon gemacht, um einen Quarzoszillator zusammen mit verschiedenen anderen elektronischen Komponenten, zum Beispiel einem Frequenzteiler, in einem einzigen Chip zu integrieren. Die Patentdokumente DE4011795, US5406230 und US5229640 zum Beispiel beschreiben verschiedene Lösungen, um dieses Ziel zu erreichen. In der Praxis müssen noch viele Schwierigkeiten überwunden werden, bevor ein wirklich zuverlässiger, billiger und miniaturisierter Quarzoszillator auf den Markt kommt.

Es ist folglich ein Ziel der Erfindung, einen verbesserten Oszillator vorzuschlagen, der in einen Chip mit geringen Ausmassen integriert ist und der in einer Chipkarte eingesetzt wird, einschliesslich in einer Chipkarte mit dem "Plug-in"-Format, wie sie beispielsweise in Mobilfunktelefonen verwendet werden (SIM-Karten).

Ein anderes Ziel ist es, einen neuen integrierten Oszillator vorzuschlagen, der ein Referenzsignal mit einer nicht fälschbaren Frequenz erzeugen kann und der beispielsweise für gesicherte Anwendungen, in welchen eine unfälschbare Zeitermittlung benötigt wird, eingesetzt werden kann.

Ein anderes Ziel ist es, eine Chipkarte mit einem integrierten Oszillator zu realisieren, mit welcher die Dauer von bestimmten Prozessen, beispielsweise die Dauer von telefonischen Anrufen im Falle einer SIM-Karte, ermittelt werden kann.

Erfindungsgemäss werden diese Ziele mit Hilfe einer im unabhängigen Vorrichtungsanspruch beschriebenen Vorrichtung und mit einem in den unabhängigen Verfahrensansprüchen beschriebenen Verfahren erreicht, wobei verschiedene Varianten in den abhängigen Ansprüchen beschrieben werden.

Insbesondere werden diese Ziele mit Hilfe eines neuen integrierten Oszillators erreicht, mit welchem ein elektrisches Signal aus einer Interferenz zwischen zwei kohärenten Lichtsignalen erzeugt wird, wobei die Lichtsignale mit einem oder mehreren integrierten Lasersendern erzeugt werden.

R. P. Braun et al. beschreiben in "Low-Phase-Noise Millimeter-Wave Generation at 64 GHz and Data Transmission Using Optical Sideband Injection Locking", IEEE Photonics Technology Letters, Vol. 10, N°5, Mai 1998, die Möglichkeit, Signale mit einer Frequenz von nur einigen Megahertz aus einer Interferenz zwischen zwei Lasersignalen zu erzeugen. Die beschriebene Vorrichtung ist für Basisstationen in einem Mobilfunknetz vorgesehen.

Andere Experimente zur Erzeugung von Mikrowellensignalen aus einer Interferenz zwischen Lasersignalen werden auch von R.P. Braun et al. in "Optical harmonic upconversion for microwave generation in bidirectional broadband mobile communication system", Electronics letters, Vol. 33 N° 22, 23. Oktober 1997, und von R.P Braun et al. in "Optical Microwave Generation and Transmission Experiments in the 12- and 60-GHz Region for wireless Communications", IEEE Transactions on microwave theory and techniques, Vol. 46, N°4, April 1998, beschrieben. Obwohl alle diese Dokumente, auf welche der Leser sich zu beziehen gebeten wird, die Erzeugung von Signalen im Mikrowellenbereich (zum Beispiel Signale mit einer Frequenz von 12 oder 60 GHz) betreffen, können mit dem gleichen Prinzip auch Signale mit einer niedrigeren Frequenz erzeugt werden, beispielsweise Signale, die durch konventionelle digitale logische Schaltungen verarbeitet werden können.

Die vorliegende Erfindung wird mit Hilfe der Beschreibung besser verständlich, welche als Beispiel angeführt ist und durch die Figuren dargestellt wird, wobei:
die Figur 1 ein Blockschema eines erfindungsgemässen Oszillators zeigt, und
die Figur 2 ein Blockschema einer erfindungsgemässen Identifizierungskarte in einem Mobilkommunikationssystem zeigt.

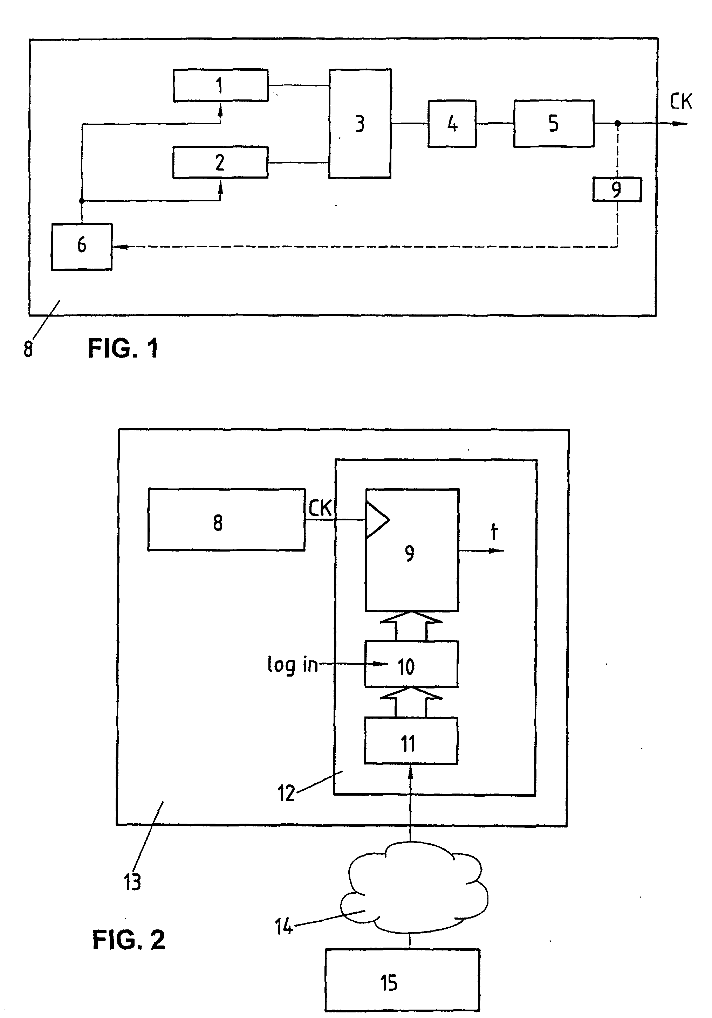

Die Figur 1 stellt schematisch die wichtigsten Komponenten eines erfindungsgemässen Oszillators 8 dar. Der Oszillator 8 umfasst im dargestellten Beispiel zwei integrierte Lasersender 1, 2, die zwei kohärente Lichtsignale mit zwei nahe beieinanderliegenden optischen Sendefrequenzen erzeugen. Integrierte Laser, die mit Halbleiter-Technologie realisiert werden und sich in Chips integrieren lassen, sind schon bekannt und wurden unter anderem von Jens Uwe Nöckel in der Neuen Zürcher Zeitung vom 24. Juni 1998, Seite 69, oder von Christian Wyss in der Neuen Zürcher Zeitung vom 12. August 1998 beschrieben. Sie basieren beispielsweise auf einem ovalen Resonator mit etwa 10 bis 80 Mikrometern Durchmesser oder auf Dioden-gepumpten Festkörperlasem.

Die gesendeten Lichtstrahlen werden auf einen optionalen optischen Koppler 3 gerichtet, der auch im Chip integriert ist und beispielsweise einfach aus einem durchsichtigen Glaselement besteht. Eine Interferenz zwischen den beiden Lichtstrahlen aus den beiden Laserquellen 1, 2 wird auf diese Weise im Koppler 3 erzeugt, wobei die Frequenz der resultierenden elektromagnetischen Welle dem Unterschied zwischen der optischen Sendefrequenz von beiden Lasersendern 1, 2 entspricht.

Wenn ein Frequenzabstand zwischen 100 MHz und 10 GHz, vorzugsweise jedoch zwischen 500 MHz und 1 GHz, gewählt wird, wird im Koppler 3 eine elektromagnetische Welle mit einer Wellenlänge zwischen ca. 0,1 und 1 Millimeter erzeugt. Diese Welle wird durch einen elektromagnetischen Konverter 4 empfangen, der vorzugsweise aus einer einfachen integrierten Empfangsantenne besteht und der einen Ausgangsstrom mit einer Frequenz, die dem Frequenzabstand zwischen den beiden gesendeten Lichtstrahlen entspricht, liefert.

Das Hochfrequenzsignal, das von der Antenne 4 erzeugt wird, wird an einen Frequenzteiler 5 gegeben, der an seinem Ausgang ein digitales Referenzsignal CK mit einer niedrigeren Frequenz abgibt, beispielsweise ein 32 KHz-Signal. Dieses Signal kann beispielsweise für die Synchronisation von Uhren oder Zeitmessern verwendet werden.

Die Sendefrequenz beider Lasersender 1, 2 wird vorzugsweise mit einem Frequenzstabilisierungselement 6 stabilisiert, das beispielsweise den in den beiden Lasersendem 1, 2 injektierten Strom steuert. In einer Variante wird ein nicht dargestelltes Peltier-Element verwendet, um elektronisch die Temperatur vom Chip und von den beiden Sendern 1, 2 zu steuern, damit die Sendefrequenz stabil bleibt. Der im Peltier-Element injektierte Strom wird vorzugsweise ebenfalls vom Stabilisierungselement 6 gesteuert.

Das Stabilisierungselement 6 wird vorzugsweise durch ein Feedback-Signal gesteuert, das von einem Frequenz-Spannungs-Konverter 9 erzeugt wird, wobei der Konverter 9 eine Spannung abgibt, die proportional zur Frequenz des Signals CK am Ausgang des Frequenzteilers 5 ist. Auf diese Weise wird die Sendefrequenz der beiden Lasersender 1,2 durch die Frequenz des Signals CK am Ausgang des gesamten Systems gesteuert.

In einer weiteren Ausführungsvariante der Erfindung wird ein einziger Lasersender verwendet, der zwei Lasersignale mit zwei verschiedenen nahe beieinanderliegenden Frequenzen erzeugt (dual mode Laser). In diesem Fall geschehen die meisten Frequenz-Abweichungen oder-Sprünge der beiden Laserstrahlen simultan, so dass der Frequenzabstand ausserordentlich stabil bleibt.

Weitere Verfahren, um eine Interferenz zwischen zwei kohärenten Laserstrahlen aus einer einzigen Lichtquelle zu gewinnen, werden unter anderem vom R.-P. Braun et al. in "Optical Millimeter-Wave Systems for Broadband Mobile Communications, Devices and Techniques", "International Zurich Seminar on Broadband Communications-Accessing, Transmission, Networking", ETH Zurich, Switzerland, Febr. 1998, beschrieben. Bekannt sind zum Beispiel Sideband-Modulation-Techniken und Mode Locked Laser (MLL).

Die Figur 2 stellt eine Identifizierungskarte 13 dar, beispielsweise eine SIM-Karte für Mobilfunkgeräte, die einen erfindungsgemässen Oszillator 8 enthält. Das Referenzsignal CK, das vom oben beschrieben Oszillator 8 erzeugt wird, wird am Takteingang eines Zählers 9 vom bekannten Typ abgegeben. Der Zähler gibt am Ausgang eine Zeitangabe t an, die von der Anzahl empfangener Pulse vom Signal CK abhängig ist. Die Zeitangabe t kann beispielsweise der absoluten Zeit oder der Dauer seit dem Beginn eines Prozesses entsprechen, beispielsweise der Dauer einer telefonischen Verbindung.

Der Wert im Zähler 9 kann zum Beispiel beim Einschalten oder beim Einloggen der Karte in ein Telekommunikationsnetz 14 mit einem in einem Initialisierungsregister 10 gespeicherten Initialisierungswert initialisiert werden. Der Initialisierungswert im Initialisierungsregister kann aus einem Zeitserver 15 femgeladen werden, der Zeitbelege an die Karte 13 senden kann. Die Zeitbelege werden vorzugsweise mittels USSD-Kurzmeldungen über ein GSM-Mobilfunknetz 14 übertragen und in einer gesicherten Speicherzone 11 der Karte 13 abgelegt; andere Typen von Datenmeldungen und von Telekommunikationssystemen können aber auch eingesetzt werden. Kryptographische Mechanismen werden vorzugsweise verwendet, um die gesendeten Zeitbelege zu signieren und um Fälschungen zu verhindern. Die Schweizer Patentanmeldung Nr. 367/98 beschreibt andere Prozesse, um die Zeit t im Zähler 9 beim Einloggen der Karte einzustellen.

Der Zähler 9 und die Register 9, 10 und 11 befinden sich vorzugsweise in einer gesicherten Zone 12 der Karte 13, so dass der vom Zähler 9 abgegebene Wert t vom Benutzer nicht gefälscht werden kann. Der Benutzer hat selbstverständfich auch keine Möglichkeiten, das vom Oszillator 8 abgegebene Frequenzsignal CK zu beeinflussen oder von aussen einzustellen.

Die vom Zähler 9 abgegebene Zeitangabe t kann beispielsweise verwendet werden, um die Dauer und den Preis von telefonischen Anrufen zu bestimmen. Auf diese Weise kann der ermittelte Betrag sofort vom Konto einer vorbezahlten SIM-Karte abgebucht werden, oder in einem signierten Beleg verpackt werden und an ein Finanzdienstleistungsunternehmen (Bank oder Netzoperator) übermittelt werden. Die erfindungsgemässe Karte kann aber auch eingesetzt werden, um die Dauer von anderen Prozessen in der Karte 13 zu messen, beispielsweise die Benutzungsdauer von bestimmten Diensten oder Anwendungen oder die Benutzung von nicht für die Verkehrsabwicklung zuständigen Ressourcen.

Es ist ausserdem auch möglich, die erfindungsgemässe Chipkarte für andere Anwendungen als die Mobilfunktelefonie einzusetzen. Solche Chipkarten können beispielsweise/auch in Pay-TV-Systemen oder in vemetzten Computem benutzt werden, beispielsweise um eine benutzungszeitabhängige Rechnung, die von der Benutzungszeit oder von der Benutzungsdauer abhängt, zu erstellen.

Der Oszillator 8 kann ein Referenzsignal CK erst dann liefern, wenn er elektrisch gespeist wird, beispielsweise wenn die Karte in einem eingeschaltenen Mobilgerät eingesteckt ist. Der Zähler 9 muss dann nach jedem neuen Einschalten des Mobilgeräts wieder eingestellt werden. Um diesen Nachteil zu vermeiden, ist es auch möglich, die Karte mit einem Energiespeicher, beispielsweise einer Batterie, zu versehen, damit die Karte elektrisch autonom ist.

Der Fachmann wird verstehen, dass der erfindungsgemässe Oszillator auch in anderen tragbaren Mobilgeräten eingesetzt werden kann, beispielsweise um ein Referenzsignal in einer Uhr zu erzeugen.

## Patentansprüche

1. Chipkarte mit einem in einem Chip integrierten Oszillator (8), welcher Oszillator (8) ein elektrisches Taktsignal (CK) mit einer Referenzfrequenz erzeugt, **dadurch gekennzeichnet,**
**dass** der Oszillator (8) mindestens einen Lasersender (1, 2) umfasst, welcher mindestens eine Lasersender (1, 2) zwei kohärente Lichtsignale mit einer unterschiedlichen optischen Sendefrequenz erzeugt,
**dass** der Oszillator (8) einen elektromagnetischen Konverter (4) umfasst, der die aus einer Interferenz zwischen den beiden benannten Lichtsignalen erzeugte Welle in ein elektrisches Signal konvertiert,
**dass** der Oszillator (8) einen Frequenzteiler (5) umfasst, der die Frequenz vom benannten elektrischen Signal teilen kann, um ein Taktsignal (CK) mit einer niedrigeren Frequenz abzugeben.

2. Chipkarte gemäss dem vorhergehenden Anspruch, **dadurch gekennzeichnet, dass** mindestens ein benannter Lasersender (1, 2) aus einem Halbleiter-Mikrolaser besteht.

3. Chipkarte nach Anspruch 2, **dadurch gekennzeichnet, dass** der benannte mindestens eine Halbleiter-Mikrolaser einen ovalen Resonator enthält.

4. Chipkarte nach Anspruch 2, **dadurch gekennzeichnet, dass** der benannte mindestens eine Halbleiter-Mikrolaser einen optisch gepumpten Festkörperlaser enthält.

5. Chipkarte nach einem der Ansprüche 1 bis 4, **dadurch gekennzeichnet, dass** der benannte Oszillator zwei unterschiedliche Lasersender (1, 2) enthält, die zwei kohärente Lichtsignale mit unterschiedlichen optischen Sendefrequenzen erzeugen.

6. Chipkarte nach einem der Ansprüche 1 bis 4, **dadurch gekennzeichnet, dass** der benannte Oszillator einen einzigen Lasersender enthält, der zwei Sendemodi besitzt.

7. Chipkarte nach einem der Ansprüche 1 bis 6, **dadurch gekennzeichnet, dass** es ein Stabilisierungselement (6) enthält, um die benannte optische Sendefrequenz des benannten mindestens einen Lasersenders zu stabilisieren.

8. Chipkarte nach einem der Ansprüche 1 bis 7, **dadurch gekennzeichnet, dass** das benannte Stabilisierungelement (6) mit der Frequenz des benannten Taktsignals (CK) gesteuert wird.

9. Chipkarte nach einem der Ansprüche 7 oder 8, **dadurch gekennzeichnet, dass** es ein Peltier-Element enthält, um die Temperatur vom benannten mindestens einen Lasersender (1, 2) zu steuern.

10. Chipkarte nach einem der Ansprüche 1 bis 9, **dadurch gekennzeichnet, dass** der Strom, der in das benannte Peltier-Element injektiert wird, von der Frequenz des benannten Taktsignals (CK) abhängig ist.

11. Chipkarte nach einem der Ansprüche 1 bis 10, **dadurch gekennzeichnet, dass** es einen Zähler (9) enthält, und dass das benannte Taktsignal (CK) am Takteingang des benannten Zählers angelegt ist.

12. Chipkarte nach einem der Ansprüche 1 bis 11, **dadurch gekennzeichnet, dass** es ein Initialisierungsregister (10) enthält, in welchem ein Initialisierungswert für den benannten Zähler abgelegt werden kann.

13. Chipkarte nach einem der Ansprüche 1 bis 12, **dadurch gekennzeichnet, dass** die Chipkarte eine Identifizierungskarte (13) ist, um Teilnehmer in einem Telekommunikationsnetz zu identifizieren.

14. Chipkarte nach Anspruch 13, **dadurch gekennzeichnet, dass** der Wert im benannten Initialisierungsregister (10) mit über das benannte Telekommunikationsnetz (14) übermittelten Kurzmeldungen geändert werden kann.

15. Chipkarte nach einem der Ansprüche 13 oder 14, **dadurch gekennzeichnet, dass** sie einen Energiespeicher enthält, der den Oszillator (8) speist.

16. Chipkarte nach einem der Ansprüche 13 bis 15, **dadurch gekennzeichnet, dass** die benannten Register in einem dem Teilnehmer nicht zugänglichen Bereich (12) der Identifizierungskarte (13) gespeichert sind.

17. Verrechnungsverfahren mit einer Chipkarte nach einem der Ansprüche 1 bis 16, um einen Anruf eines mit einer Identifizierungskarte (13) identifizierten Teilnehmers in einem Telekommunikationsnetz (14) diesem Teilnehmer zu verrechnen, wobei die Ermittlung der Dauer des Anrufs durch eine in der Identifizierungskarte (13) integrierte Zeitmessvorrichtung (8,16) durchgeführt wird, welche Zeitmessvorrichtung (8,16) einen integrierten Oszillator (8) zur Erzeugung eines elektrischen Taktsignals (CK) mit einer Referenzfrequenz umfasst, welche Referenzfrequenz aus einer Interferenz zwischen zwei kohärenten Lasersignalen erzeugt wird, mittels welcher Referenzfrequenz die gemessene Anrufsdauer ermittelt wird, und wobei der zu verrechnende Betrag in Abhängigkeit der ermittelten Anrufsdauer bestimmt wird.

18. Verrechnungsverfahren nach Anspruch 17, **dadurch gekennzeichnet, dass** ein Zeitkontroller (15) im Telekommunikationsnetz nach jedem Einloggen einer Identifizierungskarte (13) die gestellte Zeit überprüft, und, falls die Zeit nicht korrekt gestellt ist, einen Zeitbeleg an diese Identifizierungskarte übermittelt.

19. Verrechnungsverfahren nach Anspruch 18, **dadurch gekennzeichnet, dass** die übermittelten Zeitbelege elektronisch signiert werden.

20. Verrechnungsverfahren nach einem der Ansprüche 17 bis 19, **dadurch gekennzeichnet, dass** die ermittelten Beträge direkt auf einem Prepaid-Konto in der Identifizierungskarte (13) abgebucht werden.

21. Verrechnungsverfahren nach einem der Ansprüche 17 bis 19, **dadurch gekennzeichnet, dass** die ermittelten Beträge in einem signierten Beleg verpackt und an ein Finanzdienstleistungsunternehmen übermittelt werden.

22. Verrechnungsverfahren nach einem der Ansprüche 17 bis 21, **dadurch gekennzeichnet, dass** auch die Benutzung von nicht für die Verkehrsabwicklung zuständigen Ressourcen in der Identifizierungskarte (13) in Abhängigkeit von gespeicherten Tariftabellen und der benannten Zeitmessvorrichtung verrechnet wird.

## Claims

1. Chipcard with an oscillator (8) integrated into a chip, which oscillator generates an electrical clock signal (CK) with a reference frequency, **characterised in that**
the oscillator (8) comprises at least one laser transmitter (1, 2) which at least one laser transmitter (1, 2) generates two coherent light signals with a differing optical transmission frequency,
the oscillator (8) comprises an electromagnetic converter (4) which converts into an electrical signal the wave generated from an interference between the two the said light signals,
the oscillator (8) comprises a frequency divider (5), which is able to divide the frequency of the said electrical signal in order to emit a clock signal (CK) with a lower frequency.

2. Chipcard according to the preceding claim, **characterised in that** at least one said laser transmitter (1, 2) consists of a semiconductor micro-laser.

3. Chipcard according to claim 2, **characterised in that** the said at least one semiconductor micro-laser contains an oval resonator.

4. Chipcard according to claim 2, **characterised in that** the said at least one semiconductor micro-laser contains an optically pumped, solid-state laser.

5. Chipcard according to one of the claims 1 to 4, **characterised in that** the said oscillator contains two different laser transmitters (1, 2), which generate two coherent light signals with differing optical transmission frequencies.

6. Chipcard according to one of the claims 1 to 4, **characterised in that** the said oscillator possesses a single laser transmitter, which has two transmission modes.

7. Chipcard according to one of the claims 1 to 6, **characterised in that** it contains a stabilising element (6) in order to stabilise the said optical transmission frequency of the said at least one laser transmitter.

8. Chipcard according to claim 7, **characterised in that** the said stabilising element (6) is controlled with the frequency of the said clock signal (CK).

9. Chipcard according to one of the claims 7 or 8, **characterised in that** it contains a Peltier element in order to control the temperature of the said at least one laser transmitter (1, 2).

10. Chipcard according to one of the claims 1 to 9, **characterised in that** the current, which is injected into the said Peltier element, is dependent upon the frequency of the said clock signal (CK).

11. Chipcard according to one the claims 1 to 10, **characterised in that** it contains a counter (16), and **in that** the said clock signal (CK) is applied at the clock impulse input of the said counter.

12. Chipcard according to one of the claims 1 to 11, **characterised in that** it contains an initialisation register (10) in which an initialisation value for the said counter is able to be stored.

13. Chipcard according to one of the claim 1 to 12, **characterised in that** the chipcard is an identification card (13) to identify subscribers in a telecommunications network.

14. Chipcard according to claim 13, **characterised in that** the value in the said initialisation register (10) is able to be changed with short messages transmitted over the said telecommunications network (14).

15. Chipcard according to one of the claims 13 or 14, **characterised in that** it contains an energy store which feeds the oscillator (8).

16. Chipcard according to one of the claims 13 to 15, **characterised in that** the said registers are stored in an area (12) of the identification card (13) not accessible to the subscriber.

17. A billing method with a chipcard according to one of the claims 1 to 16, to bill a call of a subscriber identified with an identification card (13) in a telecommunications network (14) to this subscriber, determination of the duration of the call being carried out by means of a time-measuring device (8, 16) integrated into the identification card (13), which time-measuring device (8, 16) comprises an integrated oscillator (8) for generating an electrical clock signal (CK) with a reference frequency, the reference frequency being generated from an interference between two coherent laser signals, by means of which reference frequency the measured duration of the call is determined, and the amount to be billed being determined based on the measured duration of the call.

18. The billing method according to claim 17, **characterised in that** a time controller (15) in the telecommunications network checks the set time after each logging in of an identification card (13), and, if the time is not correctly set, transmits a time document to this identification card.

19. The billing method according to claim 18, **characterised in that** the transmitted time documents are electronically signed.

20. The billing method according to one of the claims 17 to 19, **characterised in that** the determined amounts are booked directly against a prepaid account in the identification card (13).

21. The billing method according to one of the claims 17 to 19, **characterised in that** the determined amounts are packed in a signed document, and are transmitted to a financial services provider.

22. The billing method according to one of the claims 17 to 21, **characterised in that** the use of resources in the identification card (13) not responsible for the communications transaction is billed based on stored tariff tables and the said time-measuring device.

## Revendications

1. Carte à puce comportant un oscillateur (8) intégré à une puce, oscillateur (8) qui produit un signal électrique d'horloge (CK) à une fréquence de référence, **caractérisée en ce**
**que** l'oscillateur (8) comprend au moins un émetteur à laser (1, 2), ce ou ces lasers (1, 2) produisant deux signaux de lumière cohérente ayant des fréquences optiques d'émission différentes,
**que** l'oscillateur (8) comprend un convertisseur électromagnétique (4) qui transforme en un signal électrique l'onde produite par l'interférence entre les deux signaux lumineux,
**que** l'oscillateur (8) comprend un diviseur de fréquence (5) qui est capable de diviser la fréquence du signal électrique pour délivrer un signal d'horloge (CK) de fréquence inférieure.

2. Carte à puce selon la revendication précédente, **caractérisée en ce qu'**au moins l'un des émetteurs à laser (1, 2) est un microlaser à semiconducteurs.

3. Carte à puce selon la revendication 2, **caractérisée en ce que** le microlaser à semiconducteurs qui est un minimum comprend un résonateur ovale.

4. Carte à puce selon la revendication 2, **caractérisée en ce que** le microlaser à semiconducteurs qui est un minimum comprend un laser solide à pompage optique.

5. Carte à puce selon l'une des revendications 1 à 4, **caractérisée en ce que** l'oscillateur comprend deux émetteurs à laser différents (1, 2) qui produisent deux signaux de lumière cohérente à des fréquences optiques d'émission différentes.

6. Carte à puce selon l'une des revendications 1 à 4, **caractérisée en ce que** l'oscillateur comprend un seul émetteur à laser, qui a deux modes d'émission.

7. Carte à puce selon l'une des revendications 1 à 6, **caractérisée en ce qu'**elle comporte un élément stabilisateur (6) servant à stabiliser la fréquence optique d'émission du ou des émetteurs à laser.

8. Carte à puce selon la revendication 7, **caractérisée en ce que** l'élément stabiliateur (6) est piloté par la fréquence du signal d'horloge (CK).

9. Carte à puce selon la revendication 7 ou 8, **caractérisée en ce qu'**elle comprend un élément de Peltier destiné à piloter la température du ou des émetteurs à laser (1, 2).

10. Carte à puce selon l'une des revendications 1 à 9, **caractérisée en ce que** l'intensité du courant qui est injecté dans l'élément Peltier est fonction de la fréquence du signal d'horloge (CK).

11. Carte à puce selon l'une des revendications 1 à 10, **caractérisée en ce qu'**elle contient un compteur (9) et que le signal d'horloge (CK) est appliqué à l'entrée pour signal d'horloge du compteur.

12. Carte à puce selon l'une des revendications 1 à 11, **caractérisée en ce qu'**elfe contient un regitre de démarrage (10) dans lequel on peut déposer une valeur de démarrage pour le compteur.

13. Carte à puce selon l'une des revendications 1 à 12, **caractérisée en ce que** cette carte à puce est une carte d'identification (13) servant à identifier des abonnés dans un réseau de télécommunications.

14. Carte à puce selon la revendication 13, **caractérisée en ce qu'**il est possible de modifier la valeur présente dans le registre de démarrage (10) au moyen de messages courts transmis par le réseau de télécommunications (14).

15. Carte à puce selon la revendication 13 ou 14, **caractérisée en ce qu'**elle contient un accumulateur d'énergie qui alimente l'oscillateur (8).

16. Carte à puce selon l'une des revendications 13 à 15, **caractérisée en ce que** les registres sont mis en mémoire dans une partie (12) de la carte d'identification (13) qui n'est pas accessible à l'abonné.

17. Procédé d'imputation utilisant une carte à puce selon l'une des revendications 1 à 16 et destiné à imputer, à un abonné d'un réseau de télécommunications (14), une communication de cet abonné, qui est identifié au moyen d'une carte d'identification (13), la détermination de la durée de la communication étant exécutée par un dispositif chronométrique (8, 16) intégré à la carte d'identification (13) et qui possède un oscillateur (8) intégré, qui sert à produire un signal électrique d'horloge (CK) à une fréquence de référence qui est engendrée par l'interférence entre deux signaux cohérents de lasers, et au moyen de laquelle est déterminée la durée mesurée de la communication, le montant à débiter étant déterminé en fonction de la durée déterminée de la communication.

18. Procédé d'imputation selon la revendication 17, **caractérisé en ce qu'**un contrôleur de temps (15), dans le réseau de télécommunications, vérifie l'heure réglée après chaque mise en circuit d'une carte d'identification et, si le réglage n'est pas correct, envoie un relevé de l'heure à cette carte d'identification.

19. Procédé d'imputation selon la revendication 18, **caractérisé en ce que** les relevés de l'heure qui sont transmis sont signés électroniquement.

20. Procédé d'imputation selon l'une des revendications 17 à 19, **caractérisé en ce que** les montants établis sont imputés directement à un compte prépayé, sur la carte d'identification (13).

21. Procédé d'imputation selon l'une des revendications 17 à 19, **caractérisé en ce que** les montants établis sont condensés dans un relevé signé et communiqués à une entreprise de prestation de services financiers.

22. Procédé d'imputation selon l'une des revendications 17 à 21, **caractérisé en ce que** l'utilisation de ressources de la carte d'identification (13) non affectées à l'écoulement du trafic est également débitée, en fonction de tableaux de tarifs mis en mémoire et du dispositif chronométrique.
